# EUROPEAN PATENT APPLICATION

(11) **EP 4 415 035 A1**
(43) Date of publication of application: **14.08.2024**
(21) Application number: 23155566.5
(22) Date of filing: 08.02.2023
(51) Int. Cl.: H01L 21/822, H01L 21/8238, H01L 27/06, H01L 27/092, H01L 29/06, H01L 29/66, H01L 29/775, H01L 29/786

(54) **CFET CELL ARCHITECTURE WITH A SIDE-ROUTING STRUCTURE**

(71) Applicant: Imec VZW, 3001 Leuven (BE)
(72) Inventor: MIRABELLI, Gioele, 3000 Leuven (BE); BOEMMELS, Juergen, 3001 Heverlee (BE); RYCKAERT, Julien, 1030 Schaerbeek (BE)
(74) Representative: Roth, Sebastian

(57) **Abstract**

This disclosure relates to complementary field effect transistor (CFET) devices, and is concerned with a routability of the transistor structures in a CFET cell. The disclosure presents a CFET cell (10) comprising a first transistor structure (11) in a first tier and a second transistor structure (12) in a second tier above the first tier. A first power rail (13) is arranged below the first tier and connected to the first transistor structure from below, and a second power rail (14) is formed in a first metal layer and connected to the second transistor structure from a first side. A set of signal routing lines (15) formed in a second metal layer above the second tier is connected to the first and second transistor structure from above. Further, a signal routing structure (16) formed in a metal zero (Mo) layer is connected to the first transistor structure and/or to the second transistor structure from a second side.

## Description

### TECHNICAL FIELD

The present disclosure relates to complementary field effect transistor (CFET) devices. The disclosure is concerned with a routability of stacked transistor structures in a CFET cell. The disclosure presents a CFET cell with a specifically designed signal routing structure, and a CFET device that includes at least two of these CFET cells.

### BACKGROUND

In a CFET device, different transistor structures, particularly NMOS and PMOS transistor structures, may be stacked on top of each other. Compared, for example, to a nanosheet device, which comprises NMOS and PMOS transistor structures arranged side by side with a spacing in between them, the stacking of the transistor structures enables increasing an effective channel width.

A CFET device may include one or more CFET (unit) cells. An exemplary implementation of a CFET cell may be a static random access memory (SRAM) cell, wherein two NMOS transistor structures and two PMOS transistor structures are processed in a stacked manner, and are cross-coupled to form two cross-coupled inverters of the SRAM cell.

An issue in an exemplary conventional CFET device is related to the connections of the transistor structures, especially, their connections to the power rails and to the signal routing lines.

For instance, since the signal routing lines are typically processed above the stacked transistor structures, the signals of a bottom transistor structure of two stacked transistor structures may be picked up only by using high aspect-ratio vias. Moreover, the connection of the top transistor structure to a power rail may impact the routability of the bottom transistor structure, because the bottom transistor structure may not be easily connectable to all signal routing lines in this case. In particular, the connection of the top transistor structure to the power rail may render the use of high aspect-ratio vias for connecting the bottom transistor structure to the signal routing lines impossible.

### SUMMARY

In view of the above, this disclosure aims generally for an improved CFET device. An objective is to improve the design of a CFET cell, especially regarding the connections of the transistor structures to the power rails and the signal routing lines. A particular objective is to improve the intra-cell routing and to free routing resources in upper metal layers. Another particular objective is to simplify the connections of top transistor structures to a power-rail, without the need for performing a deep etch and/or forming high aspect-ratio vias. An objective is also to leverage a bottom (back-side) contact and a back-side power rail. A further objective is to enable a scaling of a track height of the CFET cell, without penalizing routing resources and active area.

These and other objectives are achieved by the solutions of this disclosure, as described in the independent claims. Advantageous implementations are described in the dependent claims.

A first aspect of this disclosure provides a CFET cell, comprising: a first transistor structure arranged in a first tier of the CFET cell; second transistor structure arranged in a second tier of the CFET cell above the first tier; a first power rail arranged below the first tier and connected to the first transistor structure from below; a second power rail formed in a first metal layer and connected to the second transistor structure from a first side; a set of signal routing lines formed in a second metal layer above the second tier and connected to the first and the second transistor structure from above; and a signal routing structure formed in a metal zero (Mo) layer and connected to the first transistor structure and/or to the second transistor structure from a second side.

One or more transistor structures arranged in the first tier and one or more transistor structures arranged in the second tier may result in stacked transistor structures of the CFET cell. However, two particular transistor structures of the CFET cell - one in the first tier and the other one in the second tier - do not have to be arranged directly above each other (with respect to a stacking direction of the CFET cell, typically the "vertical" direction in this disclosure), but may also be arranged indirectly above each other, which means that they may be offset in a "horizontal" direction, which is perpendicular to the "vertical" or stacking direction. The CFET cell may comprise further transistor structures or other elements, which could respectively be directly above or beneath the first and second transistor structure.

Notably, in this disclosure the terms "below" and "above", "bottom" and "top", or similar terms are to be interpreted relative to each other. In particular, these terms describe opposite sides of the CFET cell, or opposite side of any element of the CFET cell. The terms may describe a relationship of elements (e.g., transistor structures, signal routing lines, power rails, etc.) of the CFET cell along the direction of stacking of the tiers. The stacking direction may thus align with the arrangement of the two tiers (or even more than two tiers) of the CFET cell. That is, the two or more tiers, which are arranged above each other, are arranged one after the other along a certain direction (the stacking direction). The relative terms could also be swapped. For instance, in the CFET cell of the first aspect, the set of signal routing lines is placed at the top side of the CFET cell (above the second tier), while the first power rail is placed at the bottom side of the CFET cell (below the first tier). However, the set of signal routing lines could also be considered being at the bottom side of the CFET cell (below the second tier), and the first power rail could be considered being at the top side of the stacked CFET cell (above the first tier).

A transistor structure in this disclosure may be or may comprise a transistor, for example a field effect transistor (FET), or may be or may comprise a more complex semiconductor-based structure, which functions like a transistor. For instance, the semiconductor-based structure may be a nanosheet structure, a fin structure, or a forksheet structure, for example, provided with a gate partly wrapping around or fully wrapping around channel portions. The latter may be for instance a gate-all-around structure. The transistor structures of the CFET cell of the first aspect may be NMOS and PMOS transistor structures. For instance, the first transistor structure maybe an NMOS transistor structure and the second transistor structure a PMOS transistor structure, or vice versa.

A set of elements in this disclosure may comprise one or more of the elements. For instance, the set of signal routing lines may comprise one or more signal routing lines, for example, three or four signal routing lines.

The signal routing lines may be formed in a metal intermediate (Mint) layer, i.e., the second metal layer may be a Mint layer. The Mint layer may be the first horizontal metal layer in the CFET cell. The metallization of the second power rail may start in the second metal layer, and may extend downwards, but this does not have to be the case. The first metal layer may be independent of and/or different from the second metal layer.

The first and the second power rails may be rails for VDD and VSS. For instance, the first power rail may be configured to supply VDD (a supply voltage), i.e., is a VDD rail, and the second power rail may be configured to supply VSS (a ground voltage or negative voltage), i.e., is a VSS rail. VDD and VSS can be swapped, if NMOS and PMOS are swapped as well for the first transistor structure and the second transistor structure.

In the CFET cell of the first aspect, the signal routing structure, which is connected from the second side to at least one of the stacked transistor structures, is a side-routing structure, as it is arranged to the sides of these transistor structures (and not exclusively above and below them). The routing structure improves the intra-cell routing in the CFET cell, and further allows freeing routing resources in the second metal layer. The design of the CFET cell of the first aspect may simplify connections of the second transistor structure to the second power rail, without the need for any deep etch processing and/or the use of high aspect-ratio vias. This also allows leveraging the first power rail as a back-side power rail. The CFET cell of the first aspect is further scalable in track height, without penalizing routing resources and active area.

In an implementation, the CFET cell further comprises a third transistor structure arranged in the first tier; and/or a fourth transistor structure arranged in the second tier; wherein the signal routing structure is connected to: the first transistor structure and the second transistor structure; or the first transistor structure and the third transistor structure; or the second transistor structure and the fourth transistor structure.

That is, the signal routing structure may connect two transistor structures in the same tier, or two transistor structures in different tiers. The CFET cell may comprise four transistor structures.

The CFET may be an SRAM cell, wherein two transistor structures in the second tier and two transistor structures in the first tier are cross-coupled to form two cross-coupled inverters of the SRAM cell.

In an implementation of the CFET cell, the signal routing structure is a three-dimensional structure, and/or is configured to route signals along at least two dimensions.

The signal routing structure may be configured to route signals, to and/or from the transistor structures to which it is connected, in even three dimensions.

In an implementation of the CFET cell, the signal routing structure extends partly in parallel and partly perpendicular to a gate of the first transistor structure and/or to a gate of the second transistor structure.

Further, the signal routing structure may extend from the first tier to the second tier, i.e., it may bridge the tiers, which may be referred to as a "vertical" extension of the signal routing structure.

In an implementation of the CFET cell, the signal routing structure comprises: a first part formed in a first Mo sub-layer in the first tier, and connected to the first transistor structure from the second side; and/or a second part formed in a second Mo sub-layer in the second tier, and connected to the second transistor structure from the second side.

In an implementation of the CFET cell, the signal routing structure is: connected by a Mo-layer contact from the second side to a source or drain of the second transistor structure; and/or connected by a Mo-layer contact from the second side to, respectively, a drain or source of the first transistor structure.

In an implementation of the CFET cell, the signal routing structure is connected by a second-metal-layer contact to at least one signal routing line of the set of signal routing lines.

In an implementation of the CFET cell, a part of the second power rail is arranged in the second tier to the first side of the second transistor structure; and/or a part of the second power rail is arranged in the first tier to the first side of the first transistor structure.

In an implementation of the CFET cell, the second power rail extends vertically to a bottom side or to a top side of the CFET cell.

In this disclosure, "vertically" may be defined by the stacking direction of the first and second tier, which may correspond to the fabrication direction of the CFET cell.

In an implementation of the CFET cell, if the second power rail extends to the bottom side of the CFET cell, an additional signal routing line is formed in the second metal layer above the second tier and to the first side of the set of signal routing lines, and is connected to the first and the second transistor structure from above.

Thus, an additional degree of freedom for providing intra-cell routing is obtained.

In an implementation of the CFET cell, the signal routing lines of the set of signal routing lines are arranged side by side, and a part of the second power rail is arranged to the first side of the set of signal routing lines.

In this case, the second power rail may be at least partly formed in the second metal layer, or the first and the second metal layer may be the same, for example, the Mint layer.

In an implementation of the CFET cell, the second power rail has a width that is equal to or larger than two times a critical dimension of the second metal layer.

The critical dimension of the second metal layer may correspond to a metal width in the second metal layer, for example, in the Mint layer. For instance, the critical dimension of the second metal layer may correspond to the respective width(s) of the signal routing lines.

This reduces the resistance of the second power rail, and the second power rail may also overlap between adjacent CFET cells in a CFET device.

In an implementation of the CFET cell, at least one of the signal routing lines of the set of signal routing lines is connected by a respective contact to a gate of the first transistor structure and/or to a gate of the second transistor structure.

In an implementation of the CFET cell, the signal routing lines of the set of signal routing lines and a half of the second power rail span together a width of the CFET cell that corresponds to a track height of 3.5T or 4T CFET cell.

In particular, the scaling down to ₃.₅T can be achieved without penalizing routing resources and active area.

A second aspect of this disclosure provides a device comprising two CFET cells according to the first aspect as such or any of its implementations, respectively, wherein: the two CFET cells are arranged side by side; and the second power rail of the two CFET cells is the same power rail, which is arranged between the transistor structures of one CFET cell and the transistor structures of the other CFET cell.

The device of the second aspect may be referred to as a CFET device, and could be an SRAM device or other memory device.

A third aspect of this disclosure provides a method of fabricating a CFET cell, the method comprising: forming a first transistor structure in a first tier of the CFET cell; forming a second transistor structure in a second tier of the CFET cell above the first tier; processing a first power rail below the first tier and connecting the power rail to the first transistor structure from below; processing a second power rail in a first metal layer and connecting it to the second transistor structure from a first side; processing a set of signal routing lines in a second metal layer above the second tier and connecting it to the first and the second transistor structure from above; and processing a signal routing structure in a metal zero (Mo) layer and connecting it to the first transistor structure and/or to the second transistor structure from a second side.

The method of the third aspect achieves the same advantages as the CFET cell of the first aspect, and may be extended by respective implementations as described above for the CFET cell of the first aspect.

Notably, the steps of the method of the third aspect do not have to be performed, necessarily, in the order in which they are described above.

### BRIEF DESCRIPTION OF THE DRAWINGS

The above described aspects and implementations are explained in the following description of embodiments with respect to the enclosed drawings:
- FIG. 1: shows a CFET cell according to this disclosure in a side view.
- FIG. 2: shows a CFET cell according to this disclosure in a perspective view.
- FIG. 3: shows a CFET cell according to this disclosure in a top view.
- FIG. 4: shows a first exemplary CFET cell according to this disclosure in a side view.
- FIG. 5: shows a second exemplary CFET cell according to this disclosure in a side view.
- FIG. 6: shows a third exemplary CFET cell according to this disclosure in a side view.
- FIG. 7: shows a CFET device according to this disclosure with two CFET cells in a side view.
- FIG. 8: shows a first exemplary CFET device according to this disclosure with two CFET cells in a side view.
- FIG. 9: shows a second exemplary CFET device according to this disclosure with two CFET cells in a side view.

### DETAILED DESCRIPTION OF EMBODIMENTS

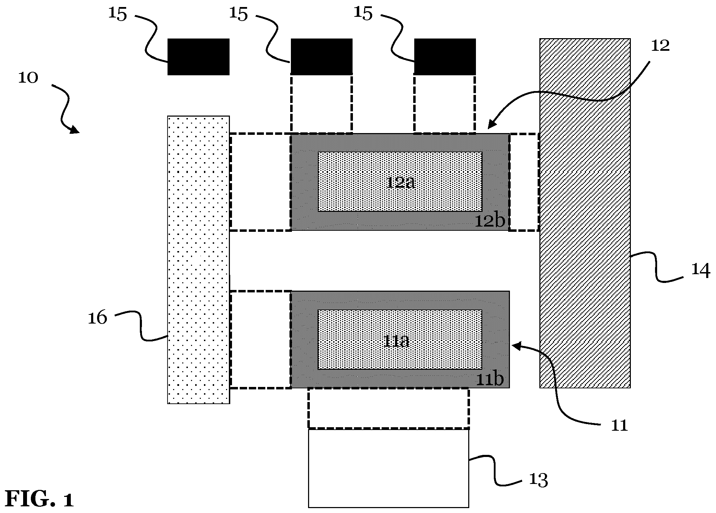

FIG. 1 shows a CFET cell 10 according to this disclosure. The CFET cell 10 may be a unit cell of a CFET device, wherein unit cell means that the CFET cell 10 could be repeated one or more times in the CFET device. For instance, multiple CFET cells 10 could be arranges side by side, or one above the other, or both. FIG. 1 shows particularly a side view of the CFET cell 10.

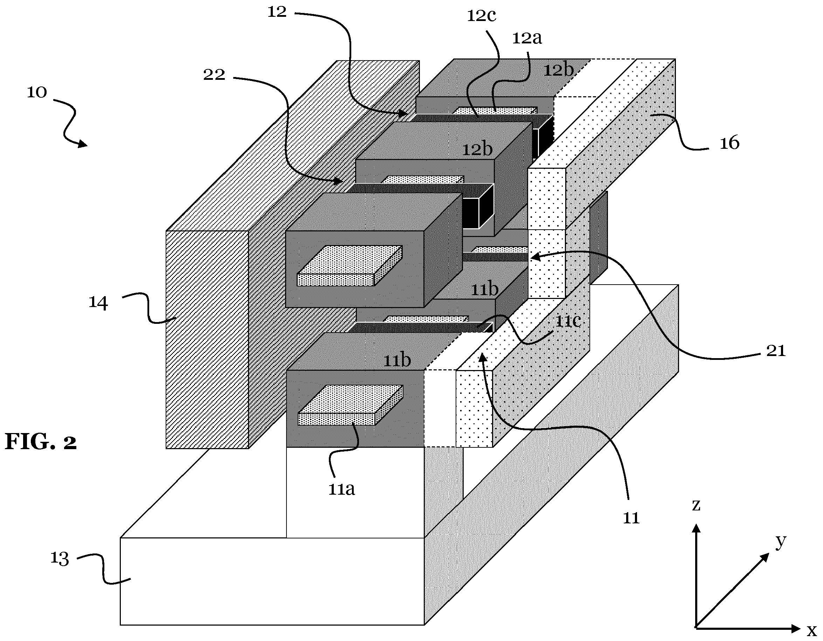

As can be seen in FIG. 1, the CFET cell 10 comprises a first transistor structure 11 arranged in a first tier (height level) of the CFET cell 10, and a second transistor structure 12 arranged in a second tier of the CFET cell 10, wherein the second tier is above the first tier (wherein above is "vertical" in FIG. 1 and corresponds to a stacking/fabrication direction of the CFET cell, may also correspond to a z-direction, see FIG. 2). Notably, FIG. 1 does not show a cross-section of the CFET cell 10, so that the second transistor structure 12 is not necessarily directly above the first transistor structure 11, but in fact may be offset from or shifted with respect to (in this case into the plane of FIG. 1) the first transistor structure 11. The CFET cell 10 may comprise further transistor structures or other elements/components, which are not shown in FIG. 1.

The CFET cell 10 further comprises a first power rail 13, which is arranged below the first tier and is connected to the first transistor structure 11 from below. A possible contact between the first power rail 13 and the first transistor structure 11 is illustrated by a dashed box in FIG. 1, but the first power rail 13 could also be connected directly to the first transistor structure 11 from below. The first power rail 13 may be a back-side power rail, and may be connected to the first transistor structure by a back-side contact.

The CFET cell 10 further comprises a second power rail 14, which is formed in a first metal layer and is connected to the second transistor structure 12 from a first side (the right side in FIG. 1). A possible contact between the second power rail 14 and the second transistor structure 12 is illustrated by a dashed box, but the second power rail 14 could also be connected directly to the second transistor structure 12.

The CFET cell 10 further comprises a set of signal routing lines 15, which is formed in a second metal layer above the second tier, and wherein the signal routing lines 15 are connected to the first and the second transistor structure 11 from above. Possible contacts between the signal routing lines 15 and the second transistor structure 12 are illustrated by respective dashed boxes in FIG. 1. For instance, the set of signal routing lines 15 may be connected by a respective contact to a gate of the first transistor structure 11 and/or to a gate of the second transistor structure 12. The respective contacts may be vias in this case.

The CFET cell 10 further comprises a signal routing structure 16, which is formed in a metal zero (Mo) layer and is connected to the first transistor structure 11 and/or to the second transistor structure 12 from a second side (the left side in FIG. 1). In FIG. 1, the signal routing structure 16 is connected to both the first transistor structure 11 and the second transistor structure 12. Possible contacts between the signal routing structure 16 and the two transistor structures 11, 12 are shown as respective dashed boxes. For instance, the signal routing structure 16 may be connected by a Mo-layer contact from the second side to the second transistor structure 12, and/or maybe connected by a Mo-layer contact from the second side to the first transistor structure 11. However, also a direct connection without contacts is potentially possible, if not preferred.

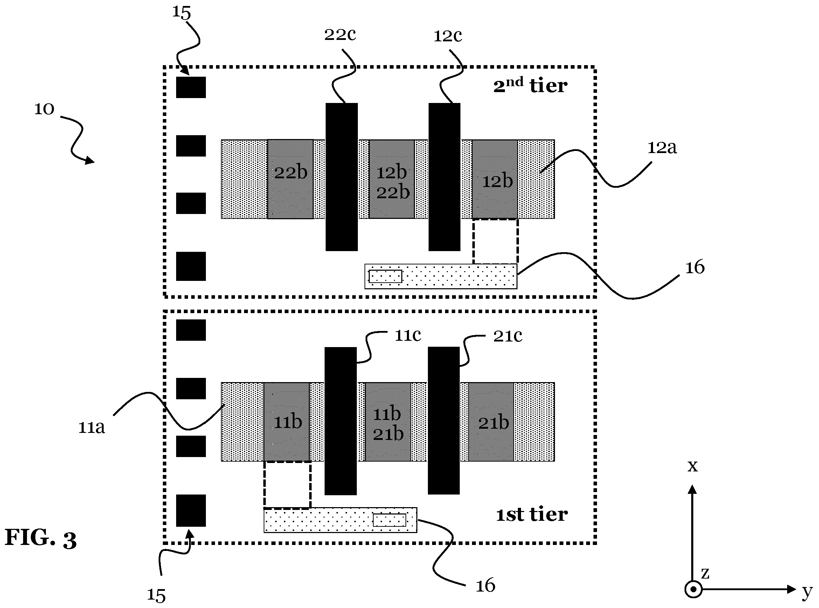

FIG. 2 shows a CFET cell 10 according to this disclosure in a perspective view (its extension in x-, y- and z-direction, as indicated by the Cartesian coordinate system in FIG. 2), and FIG. 3 shows the same CFET cell 10 in a top view (its extension in x- and y-directions, as indicated by the Cartesian coordinate system in FIG. 3). The CFET cell 10 of FIG. 2 and FIG. 3 may build on or may be the CFET cell shown in FIG. 1. Same elements in the figures are labelled with the same reference signs.

As can be seen in the FIGs. 2 and 3, the CFET cell 10 comprises - like the CFET cell 10 of FIG. 1 - a first transistor structure 11 arranged in a first tier, a second transistor structure 12 arranged in a second tier, and further comprises a third transistor structure 21 arranged in the first tier, and a fourth transistor structure 22 arranged in the second tier. The signal routing structure 16 is connected to the first transistor structure 11 and to the second transistor structure 12. In particular, the signal routing structure 16 is connected from the second side to a source/drain 12b of the second transistor structure 12, and is connected from the second side to a source/drain 11b of the first transistor structure 11. As shown in FIG. 3, the transistor structures within the same tier can be arranged side by side and/or in series, and can thereby share a source/drain contact. For example, the source/drain 12b/22b may be shared by the second transistor structure 12 and the fourth transistor structure 22, and the source/drain contact 11b/21b maybe shared by the first transistor structure 11 and the third transistor structure 21. The name "source/drain" indicates that this contact or region could act as source and drain at the same time, for instance, depending on which transistor structure is considered.

Notably, in an alternative embodiment (not shown), the signal routing structure 16 could instead be connected to the first transistor structure 11 and the third transistor structure 21 (thus, a connection in the first tier), or could be connected to the second transistor structure 12 and the fourth transistor structure 22 (thus, a connection in the second tier).

As can also be seen in FIG. 2, the signal routing structure 16 of the CFET cell 10 may be a three-dimensional structure. The signal routing structure 16 may be configured to route signals along two dimensions or along three dimensions. For instance, the signal routing structure 16 can extend partly perpendicular and optionally partly in parallel to a gate 11c of the first transistor structure 11 and/or to a gate 12c of the second transistor structure 12. For instance, the gates 11c and 12c may respectively extend into the x-direction, and the signal routing structure 16 may extend partly into the y-direction (see FIG. 3). Further, the signal routing structure 16 may extend from the second tier to the first tier and thus partly along the z-direction (as shown in the example of FIG. 2). The signal routing structure 16 can route signals along its directions of extension, for instance can route signal along the y-direction and along the ("vertical") z-direction. The signal routing structure 16 may additionally also extend partly into the x-direction, and may route signals along the x-direction.

As shown further in FIG. 2, the signal routing structure 16 may be spatially aligned with the first transistor structure 11 and the second transistor structure 12, respectively. For instance the signal routing structure 16 may be aligned in y-direction with the source/drain 11b of the first transistor structure 11 and with the source/drain 12b of the second transistor structure 12, respectively. Further the part of the signal routing structure 16 that is connected to the first transistor structure 11 maybe aligned in height, i.e., in z-direction, with the source/drain 11b of the first transistor structure 11, and the part of the signal routing structure 16 that is connected to the second transistor structure 12 may be aligned in height, i.e., in z-direction, with the source/drain 12b of the second transistor structure 12. The above-described FIGs. 1 to 3 illustrate the improvements provided by the new architecture of the CFET cell 10 of this disclosure. A first side of the CFET cell 10 (corresponding to the right side in FIG. 1, and the left side in FIG. 2) is optimized for power delivery to the transistor structures, while a second side of the CFET cell 10 (corresponding to the left side in FIG. 1, and the right side in FIG. 2) is optimized for signal routing to the transistor structures.

The CFET cell 10 of this disclosure provides specifically the following advantages. Firstly, there is no need for the use of high aspect-ratio and high-resistive vias for the power delivery to the transistor structures. This results also in an easier and less complex processing of the CFET cell 10. The CFET cell 10 may for this reason also have an improved power supply, and thus a better performance, for instance, because of less IR-drops and/or less parasitics due to smaller vias. Also the signal routing is improved, especially the intra-cell routing.

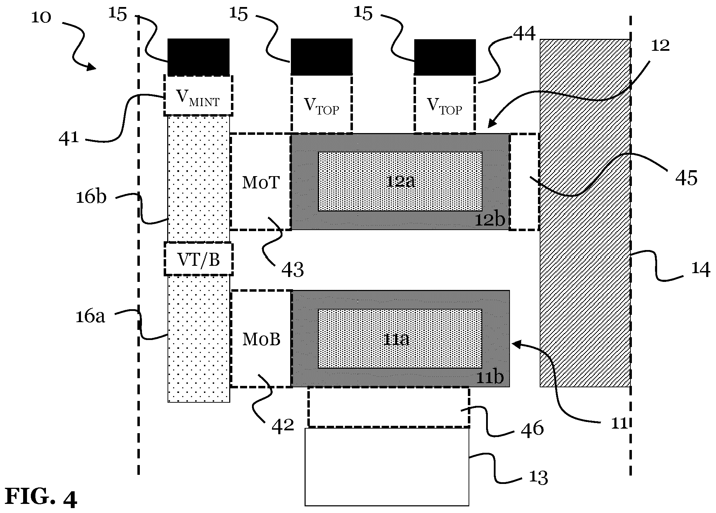

FIG. 4 shows a first exemplary CFET cell 10 according to this disclosure in a side view, similar as in FIG. 1. The CFET cell 10 of FIG. 4 may build on any CFET cell 10 of the previous figures.

FIG. 4 shows that the second power rail 14 is arranged both in the second tier to the first side of the second transistor structure 12, and in the first tier to the first side of the first transistor structure 11. The second power rail 14 extends vertically, in particular, from a top side of the CFET cell 10 to a bottom side of the CFET cell 10. The second power rail 14 may be connected to the second transistor structure by a contact 45, e.g. a Mo contact. The Mo contact may be an Mo-layer-extension. For example, the Mo layer may be patterned to form the Mo contact. A part of the second power rail 14 is accordingly arranged next to the set of signal routing lines 15 at the top side of the CFET cell 10. The signal routing lines 15 may be arranged side by side, and said part of the second power rail 14 may be arranged to the first side of the set of signal routing lines 15. At least this part of the second power rail 14 may be formed in the same metal layer, e.g. the Mint layer, as the signal routing lines 15. The top of the second power rail 14 may be aligned with the top of the second metal layer, in which the signal routing lines 15 are formed. In the exemplary CFET cell 10 of FIG. 4, the second power rail 14 is as "tall" as possible, i.e., has a maximum extension in the vertical direction (from top to bottom side of the CFET cell 10). This allows having a low resistance of the second power rail 14, particularly, since power can be connected/provide to the second power rail 14 from both the top and the bottom side of the CFET cell 10.

At least one of the signal routing lines 15 is connected by a respective contact 44 to a gate of the first transistor structure 11, and at least one of the signal routing lines 15 is connected by a respective contact 44 to a gate of the second transistor structure 12.

FIG. 4 also shows that the signal routing structure 16 comprises a first part 16a and a second part 16b. The first part 16a may be formed in a first Mo sub-layer and in the first tier, and is connected to the first transistor structure 11 from the second side. The second part 16b may be formed in a second Mo sub-layer and in the second tier, and is connected to the second transistor structure 12 from the second side. The first Mo sub-layer maybe a MoB layer, and the second Mo sub-layer may be a MoT layer. The signal routing structure 16 may be connected by a first Mo-layer contact 43 from the second side to the second transistors structure 12, particularly to a source/drain 12b of the second transistor structure 12. Further, the signal routing structure 16 may be connected by a second Mo-layer contact 42 from the second side to the first transistor structure 11, particularly, to a source/drain 11b of the first transistor structure 11. The MoT and MoB layers for connecting the signal routing structure may run perpendicularly to the gates 11c, 12c of the transistor structures 11, 12.

The signal routing structure 16 may, in addition, be connected by a second-metal-layer contact 41, for instance a Mint layer contact, to at least one signal routing line 15 of the set of signal routing lines 15, e.g. as illustrated.

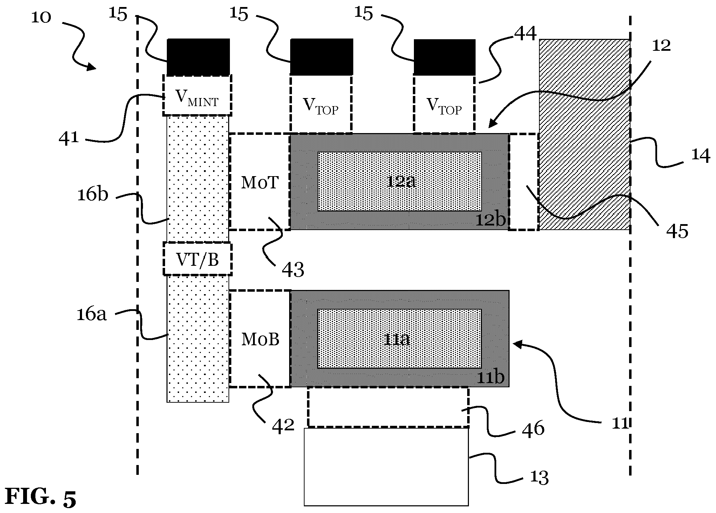

FIG. 5 shows a second exemplary CFET cell according to this disclosure in a side view, similar as in FIG. 1. The CFET cell 10 of FIG. 5 may build on any CFET cell 10 shown in the previous figures.

In FIG. 5 - compared to FIG. 4 - while a part of the second power rail 14 is arranged in the second tier to the first side of the second transistor structure 12, the second power rail 14 is not arranged in the first tier. The second power rail 14 extends, from the second tier, vertically to only a top side of the CFET cell 10, where a part of the second power rail 14 is arranged next to the signal routing lines 15 as in FIG. 4.

In the CFET cell 10 of FIG. 5, the second power rail 14 may have a higher resistance than the second power rail 14 in the CFET cell 10 of FIG. 4. However, the advantage of a lower parasitic capacitance between the second power rail 14 and first transistor structure 11 is achieved.

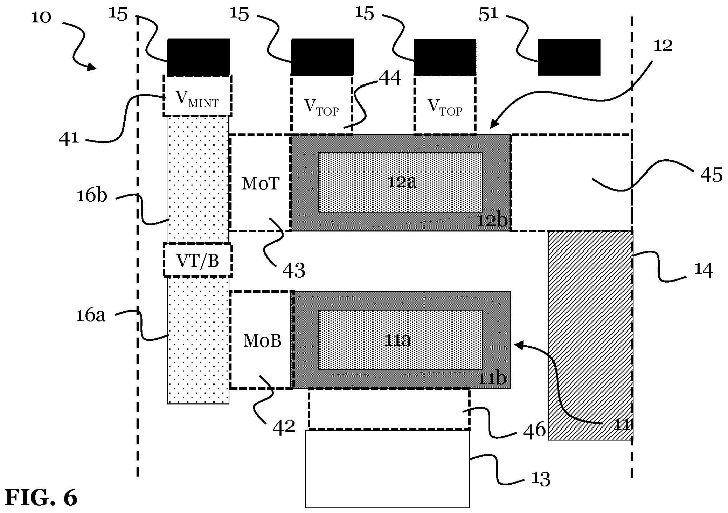

FIG. 6 shows a third exemplary CFET cell according to this disclosure in a side view, similar as in FIG. 1. The CFET cell 10 of FIG. 5 may build on any CFET cell 10 shown in the previous figures.

In the CFET cell 10 of FIG. 6, a part of the second power rail 14 is arranged in the first tier to the first side of the second transistor structure 12. Another part of the second power rail 14, or a contact used for contacting the second power rail 14 to the second transistor structure 12, may be arranged in the second tier. The second power rail 14 extends, from the first tier, vertically, to the bottom side of the CFET cell 10, and to the second tier. However, the second power rail 14 does not extend to the top side of the CFET cell 10.

Due to the free space at the top side of the CFET cell 10, an additional signal routing line 51 can be formed in the second metal layer, e.g. the Mint layer, above the second tier and to the first side of the set of signal routing lines 15. The additional signal routing line 51 could be connected to the first and/or the second transistor structure 11, 12 from above. Generally, the additional signal routing line 51 can be beneficial for intra-cell and/or inter-cell routing and connectivity, wherein the inter-cell connectivity may include the connectivity of different CFET cells 10 that are not necessarily close together in a CFET device.

In the CFET cell 10 of FIG. 5, the second power rail 14 may have a higher resistance than the one in FIG. 4. However, as an advantage, the second power rail 14 can be easily connected to a backside rail, and the extra signal routing line 51 on the top side of the CFET cell 10 becomes possible.

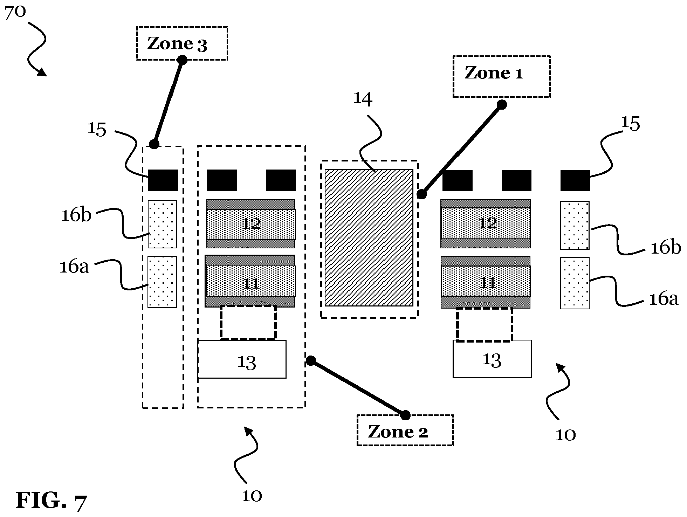

FIG. 7 shows a CFET device 70 according to this disclosure. The CFET device 70 is particularly shown with two CFET cells 10 and in a side view. The two CFET cells 10 are arranged side by side, and the second power rail 14 is common to both of the two CFET cells 10, i.e., it is the same power rail for each CFET cell 10. The second power rail 14 is arranged between the transistor structures 11, 12 of one of the two CFET cells 10 and the transistor structures 11, 12 of the other one of the two CFET cells 10.

Thus, the center of the CFET device 70 between the two CFET cells 10 can be optimized for power-delivery (zone 1). Each CFET cell 10 has three signal routing lines 15. A fourth signal routing line 15 of the CFET cells 10 was sacrificed to form the deep and wide second power rail 14. The second power rail 14 may particularly have a width (e.g., in x-direction) that is equal to or larger than two times a critical dimension of the second metal layer, in which the signal routing lines 15 are formed, for instance the Mint layer. The second power rail 14 may further particularly be as deep as from the top side of the CFET cells 10 to the bottom side, as illustrated and as in FIG. 4. However, the CFET device 70 may also include CFET cells 10 as in FIG. 5 or FIG. 6.

Connections of the second transistor structures 12 of the two CFET cells 10 to the second power rail 14, e.g. for VSS, may be done through an extension of the top Mo layer (MoT). This may improve the power drop on the second power rail 14 due to its wider dimension. The connections of the transistor structures 11, 12 of the two CFET cells 10 to MoT, or to the respective gates, may be done through the inner two signal routing lines 15 (zone 2), in the middle of the respective CFET cell 10. Finally, through the outer signal routing line 15 (zone 3), it is possible to pick up both signals of the first and second transistor structures 11, 12 in the respective CFET cells 10 via the signal routing structure 16. A specific fingerprint is that the signal routing structure 16 is not only vertical, to allow the connection to their respective transistors structures 11, 12, but can also route signals perpendicularly to the gate(s) 11c, 12c.

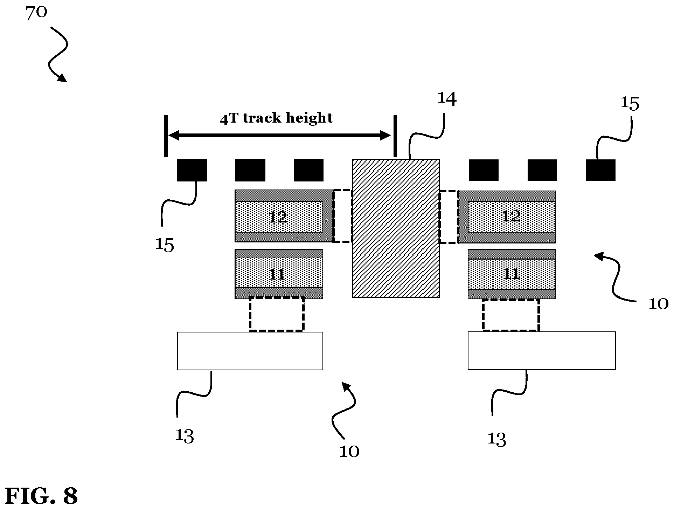

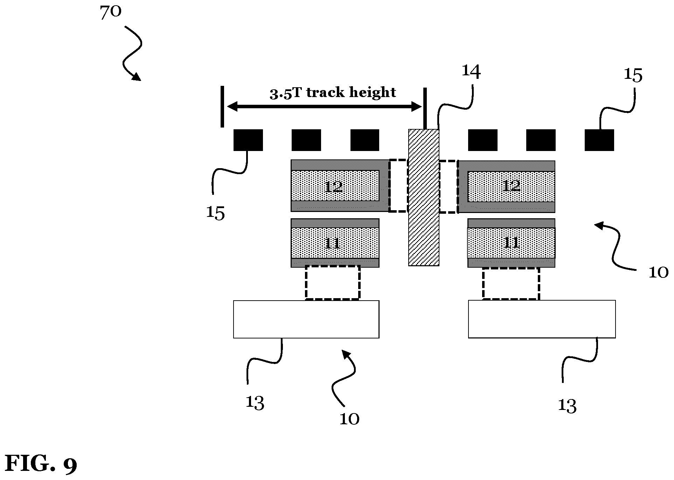

FIG. 8 shows a first exemplary CFET device 70 according to this disclosure with two CFET cells 10 in a side view, which builds on FIG. 7. The signal routing lines 15 of the set of signal routing lines 15 and a half of the second power rail 14 span together a width of each CFET cell 10 that corresponds to a track height of a 4T CFET cell. FIG. 9 shows a second exemplary CFET device 70 according to this disclosure with two CFET cells 10 in a side view, which builds on FIG. 7. Here the signal routing lines 15 of the set of signal routing lines 15 and a half of the second power rail 14 span together a width of each CFET cell 10 that corresponds to a track height of a 3.5T CFET cell.

CFET scaling from 4T to 3.5T with classic architectures is achieved by sacrificing the width of the active region. In the CFET cell architecture of this disclosure, the power rail(s) 13, 14 and the active width can be optimized to further scale the standard cell height of the CFET cell 10, without impacting the routing resources. In this example the second power rail's 14 width is reduced (see FIG. 8 compared to FIG. 7) to allow track height scaling without impacting the active width or the routability of the architecture.

In summary, in this disclosure a new CFET cell layout has been proposed to optimize the routing resources, as well as the connections to the power rails. The CFET cell layout can be designed for 4T CFET cells in a CFET device. One side of the CFET cell 10 is designed to optimize its routing resources, using the signal routing structure 16. The signal routing structure 16 can stretch both vertically and horizontally, thus simplifying the intra-cell routing and freeing routing resources on the top side layers of the CFET cell. The other side of the CFET cell 10 is designed to optimize the connection of the (top) second transistor structure 12 to the power rail 14. The connection may be done through a vertically extending power rail in a metal layer, e.g., Mo or Mint layer, thus removing the need for high aspect ratio vias. In addition, the second power rail 14 may extend between two consecutive CFET cells 10 of a CFET device 70, so as to reduce its resistance and thus power consumption. Finally, the CFET cell 10 track height can be scaled by reducing the second power rail dimension and/or active width, in order to achieve ₃.₅T CFET cells in a CFET device 70.

In the claims as well as in the description of this disclosure, the word "comprising" does not exclude other elements or steps and the indefinite article "a" or "an" does not exclude a plurality. A single element may fulfill the functions of several entities or items recited in the claims. The mere fact that certain measures are recited in the mutual different dependent claims does not indicate that a combination of these measures cannot be used in an advantageous implementation.

## Claims

1. A complementary field effect transistor, CFET, cell (10), comprising:
a first transistor structure (11) arranged in a first tier of the CFET cell (10);
a second transistor structure (12) arranged in a second tier of the CFET cell (10) above the first tier;
a first power rail (13) arranged below the first tier and connected to the first transistor structure (11) from below;
a second power rail (14) formed in a first metal layer and connected to the second transistor structure (12) from a first side;
a set of signal routing lines (15) formed in a second metal layer above the second tier and connected to the first and the second transistor structure (11) from above; and
a signal routing structure (16) formed in a metal zero, Mo, layer and connected to the first transistor structure (11) and/or to the second transistor structure (12) from a second side.

2. The CFET cell (10) according to claim 1, further comprising:
a third transistor structure (21) arranged in the first tier; and/or
a fourth transistor structure (22) arranged in the second tier;
wherein the signal routing structure (16) is connected to:
- the first transistor structure (11) and the second transistor structure (12); or
- the first transistor structure (11) and the third transistor structure (21); or
- the second transistor structure (12) and the fourth transistor structure (22).

3. The CFET cell (10) according to claim 1 or 2, wherein the signal routing structure (16) is a three-dimensional structure, and/or is configured to route signals along at least two dimensions.

4. The CFET cell (10) according to one of the claims 1 to 3, wherein the signal routing structure (16) extends partly in parallel and partly perpendicular to a gate (11c) of the first transistor structure (11) and/or to a gate (12c) of the second transistor structure (12).

5. The CFET cell (10) according to one of the claims 1 to 4, wherein the signal routing structure (16) comprises:
a first part (16a) formed in a first Mo sub-layer in the first tier, and connected to the first transistor structure (11) from the second side; and/or
a second part (16b) formed in a second Mo sub-layer in the second tier, and connected to the second transistor structure (12) from the second side.

6. The CFET cell (10) according to one of the claims 1 to 5, wherein the signal routing structure (16) is:
connected by a Mo-layer contact (43) from the second side to a source or drain (12b) of the second transistor structure (12); and/or
connected by a Mo-layer contact (42) from the second side to, respectively, a drain or source (11b) of the first transistor structure (11).

7. The CFET cell (10) according to one of the claims 1 to 6, wherein the signal routing structure (16) is connected by a second-metal-layer contact (41) to at least one signal routing line (15) of the set of signal routing lines (15).

8. The CFET cell (10) according to one of the claims 1 to 7, wherein:
a part of the second power rail (14) is arranged in the second tier to the first side of the second transistor structure (12); and/or
a part of the second power rail (14) is arranged in the first tier to the first side of the first transistor structure (11).

9. The CFET cell (10) according to claim 8, wherein the second power rail (14) extends vertically to a bottom side or to a top side of the CFET cell (10).

10. The CFET cell (10) according to claim 9, wherein, if the second power rail (14) extends to the bottom side of the CFET cell (10), an additional signal routing line (51) is formed in the second metal layer above the second tier and to the first side of the set of signal routing lines (15), and is connected to the first and the second transistor structure (11, 12) from above.

11. The CFET cell (10) according to one of the claims 1 to 9, wherein the signal routing lines (15) of the set of signal routing lines (15) are arranged side by side, and a part of the second power rail (14) is arranged to the first side of the set of signal routing lines (15).

12. The CFET cell (10) according to one of the claims 1 to 11, wherein the second power rail (14) has a width that is equal to or larger than two times a critical dimension of the second metal layer.

13. The CFET cell (10) according to one of the claims 1 to 12, wherein at least one of the signal routing lines (15) of the set of signal routing lines (15) is connected by a respective contact (44) to a gate (11c) of the first transistor structure (11) and/or to a gate (12c) of the second transistor structure (12).

14. The CFET cell (10) according to claim 13, wherein the signal routing lines (15) of the set of signal routing lines (15) and a half of the second power rail (14) span together a width of the CFET cell (10) that corresponds to a track height of a ₃.₅T or 4T CFET cell (10).

15. A device (70) comprising two CFET cells (10) according to one of the claims 1 to 14, respectively wherein:
the two CFET cells (10) are arranged side by side; and
the second power rail (14) of the two CFET cells (10) is the same power rail, which is arranged between the transistor structures (11, 12, 21, 22) of one CFET cell (10) and the transistor structures (11, 12, 21, 22) of the other CFET cell (10).
